(19) Europäisches Patentamt
European Patent Office
Office européen des brevets

(11) **EP 4 597 149 A1**

(12) **EUROPEAN PATENT APPLICATION**

(43) Date of publication:
**06.08.2025 Bulletin 2025/32**

(21) Application number: **24155755.2**

(22) Date of filing: **05.02.2024**

(51) International Patent Classification (IPC):
***G01R 33/565*** *(2006.01)* ***G01R 33/48*** *(2006.01)*
***G01R 33/56*** *(2006.01)*

(52) Cooperative Patent Classification (CPC):
**G01R 33/56509; G01R 33/4818; G01R 33/5608**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Koninklijke Philips N.V.**
**5656 AG Eindhoven (NL)**

(72) Inventors:
- **DONEVA, Mariya Ivanova**
  **Eindhoven (NL)**
- **EGGERS, Holger**
  **Eindhoven (NL)**
- **MEINEKE, Jan Jakob**
  **5656AG Eindhoven (NL)**
- **SELIVANOV, Alexander**
  **Eindhoven (NL)**

(74) Representative: **Philips Intellectual Property & Standards**
**High Tech Campus 52**
**5656 AG Eindhoven (NL)**

(54) **SPATIALLY ADAPTIVE MAGNETIC RESONANCE IMAGING**

(57) Disclosed herein are systems and associated methods of medical imaging. An embodiment of the method comprises receiving (200) measured k-space data (122), wherein the measured k-space data comprises blades of k-space data acquired according to a rotated magnetic resonance imaging protocol. For the blades of the k-space data, the method further comprises: reconstructing (202) a blade-specific image (124); and assigning (204) a spatially dependent weighting score (128) to individual voxels of the blade-specific image by comparing the blade-specific image to a reference image (126). The method further comprises reconstructing (208) a magnetic resonance image (134) by combining the blade-specific images, wherein the reconstruction of the magnetic resonance image is guided using the spatially dependent weighting score of the individual voxels of the blade specific image for the respective blades of k-space data.

receive measured k-space data, wherein the measured k-space data comprises blades of k-space data acquired according to a PROPELLER magnetic resonance imaging protocol
200
reconstruct a blade specific image
202
assign a spatially dependent weighting score to individual voxels of the blade specific image by comparing the blade specific image to a reference image
204
finished with all blade specific images?
No
Yes
206
reconstruct a magnetic resonance image by combining the blade specific images with the reconstruction of the magnetic resonance image being guided using the spatially dependent weighting score of the individual voxels of the blade specific image for the respective blades of k-space data
208

Fig. 2

EP 4 597 149 A1

## Description

TECHNICAL FIELD

The invention relates to magnetic resonance imaging, in particular to magnetic resonance imaging systems and methods.

BACKGROUND

A large static magnetic field is used by Magnetic Resonance Imaging (MRI) scanners to align the nuclear spins of atoms as part of the procedure for producing images within the body of a patient. This large static magnetic field is referred to as the $B_0$ field or the main magnetic field. Various quantities or properties of the subject can be measured spatially and imaged using MRI. A difficulty with performing MRI is that it takes time to acquire the k-space data, which increases the likelihood that the subject moves in the process, causing blurring and other motion artifacts in the resulting magnetic resonance image.

One way of dealing with these motion artifacts is to use a Periodically Rotated Overlapping ParallEL Lines with Enhanced Reconstruction (PROPELLER) magnetic resonance imaging protocol, also known as MultiVane, Blade, Radar, Jet, according to trade names of various vendors. In PROPELLER MRI the trajectory along which the k-space data is acquired is defined by a series of sequentially acquired "blades". Each blade comprises multiple parallel phase-encoded lines and is rotated in k-space relative to the other blades. The advantage of this is that a low resolution "blade specific image" can be reconstructed from each blade and that the central region of k-space is heavily oversampled. A comparison of these blade specific images can be used to identify subject motion and to correct for the subject motion. A conventional PROPELLER reconstruction is able to correct for rigid body motion of the subject.

Gadjimuradov F., et. al, "Deep learning-guided weighted averaging for signal dropout compensation in DWI of the liver," Magn Reson Med. 2022 Dec;88(6):2679-2693. doi: 10.1002/mrm.29380. Epub 2022 Aug 2. PMID: 35916385 discloses an algorithm for the retrospective correction of signal dropout artifacts in abdominal DWI resulting from cardiac motion. Given a set of image repetitions for a slice, a locally adaptive weighted averaging is proposed that aims to suppress the contribution of image regions affected by signal dropouts. Corresponding weight maps were estimated by a sliding-window algorithm, which analyzed signal deviations from a patch-wise reference. In order to ensure the computation of a robust reference, repetitions were filtered by a classifier that was trained to detect images corrupted by signal dropouts.

SUMMARY

The invention provides for a medical system, a method, and a computer program in the independent claims. Embodiments are given in the dependent claims.

In one aspect, the invention provides for a medical system that comprises a memory storing machine-executable instructions. The medical system further comprises a computational system. Execution of the machine-executable instructions causes the computational system to receive measured k-space data. The measured k-space data comprises blades of k-space data acquired according to a rotated magnetic resonance imaging protocol. For the blades of the k-space data, execution of the machine-executable instructions further causes the computational system to reconstruct a blade specific image. For the blades of the k-space data, execution of the machine-executable instructions further causes the computational system to assign a spatially dependent weighting score to individual voxels of the blade specific image by comparing the blade specific image to a reference image. Execution of the machine-executable instructions further causes the computational system to reconstruct a magnetic resonance image by combining the blade specific images. The reconstruction of the magnetic resonance image is guided using the spatially dependent weighting score of the individual voxels of the blade specific image for the respective blades of k-space data.

In one embodiment the reconstruction of the magnetic resonance image is formulated as an optimization problem to iteratively minimize a cost function, wherein the cost function comprises a difference between the blade specific image and the projection of the magnetic resonance image obtained from a previous iteration onto a blade specific image space for the blades of k-space data. The optimization problem may further comprise weighting the cost function with the spatially dependent weighting score for the blade specific images before minimization.

In any of the embodiments the magnetic resonance imaging protocol may be a compressed sensing magnetic resonance imaging protocol, wherein the reconstruction of the magnetic resonance image may further comprise adding a residual term that is dependent upon the magnetic resonance image obtained from the previous iteration to a solution of the optimization problem, and wherein the residual term may be calculated using a compressed sensing reconstruction algorithm.

In some embodiments the magnetic resonance imaging protocol may be a parallel imaging magnetic resonance imaging protocol, wherein the blade-specific images and the projection of the magnetic resonance image obtained from a previous iteration to a solution of the optimization problem onto the blade-specific image space may be calculated for individual coil elements.

In any of the embodiments execution of the machine-executable instructions may further cause the computational system, for the blades of the k-space data to: determine a motion estimate (or approximation) using the blade specific image before assigning the spatially dependent weighting score and perform motion correction on the blade specific image before assigning the spatially dependent weighting score if the motion estimate is above a predetermined motion threshold. The motion correction may further comprise any one of the following: deleting the blade specific image and translating the blade specific image using the motion estimate and/or rotating the blade-specific image using the motion estimate.

Any of the embodiments of the medical system may further comprise a magnetic resonance imaging system, wherein the memory further stores pulse sequence commands configured to control the magnetic resonance imaging system to acquire the measured k-space data according to the rotated magnetic resonance imaging protocol, wherein execution of the machine-executable instructions further causes the computational system to acquire the measured k-space data by controlling the magnetic resonance imaging system with the pulse sequence commands.

In some of the embodiments the reference image may be a predetermined image of the blade specific images for the blades of k-space data.

The execution of the machine-executable instructions may further cause the computational system to: calculate an intermediate composite image by summing at least two of the blade specific images and provide the intermediate composite image as the reference image. Execution of the machine-executable instructions may further cause the computational system to determine a similarity metric between the intermediate composite image and the at least two of the blade specific images and recalculate the intermediate composite image by omitting any blade specific image with a similarity metric that meets a predetermined criterion from the summation.

In any of the embodiments, assignment of the spatially dependent weighting score to individual voxels of the blade specific image may be performed by inputting the blade-specific image and the reference image into a comparison algorithm, wherein the comparison algorithm may be any one of the following: a structural similarity index measure, a cosine similarity index measure, and an Adaptive Weighted Averaging (AWA) algorithm.

In some embodiments of the medical system the memory may further comprise a comparison neural network configured to output the spatially dependent weighting score in response to receiving the blade-specific image and the reference image as input, wherein execution of the machine-executable instructions may further cause the computational system to receive the spatially dependent weighting score in response to inputting the blade specific image and the reference image into the comparison neural network.

In another aspect, the invention provides for a method of medical imaging. The method comprises receiving measured k-space data. The measured k-space data comprises blades of k-space data acquired according to a rotated magnetic resonance imaging protocol. For the blades of k-space data, the method further comprises reconstructing a blade specific image. For the blades of k-space data, the method further comprises assigning a spatially dependent weighting score to individual voxels of the blade specific image by comparing the blade specific image to a reference image. The method further comprises reconstructing a magnetic resonance image by combining the blade specific images. The reconstruction of the magnetic resonance image is guided using the spatially dependent weighting score of the individual voxels of the blade specific image for the respective blades of k-space data.

Further embodiments of the method have features in conformance with features disclosed in relation to corresponding system embodiments.

In another aspect, the invention provides for a computer program that comprises machine-executable instructions configured for causing a processor or a computational system to perform a method according to any of the embodiments.

In any of the embodiments according to any of the aspects of the invention the rotated magnetic resonance imaging protocol may be or may comprise periodically rotated magnetic resonance imaging protocol, preferably a periodically rotated overlapping parallel lines with enhanced reconstruction (PROPELLER) magnetic resonance imaging protocol.

## BRIEF DESCRIPTION OF THE DRAWINGS

In the following preferred embodiments of the invention will be described, by way of example only, and with reference to the drawings in which:

Fig. 1 illustrates an example of a medical system.
Fig. 2 shows a flow chart which illustrates a method of using the medical system of Fig. 1.
Fig. 3 illustrates a further example of a medical system.
Fig. 4 shows a flow chart which illustrates a method of using the medical system of Fig. 3.

Fig. 5 shows a comparison of two magnetic resonance images: one reconstructed using a conventional PROPELLER reconstruction and a second reconstructed according to an example according to the invention.

DESCRIPTION OF EMBODIMENTS

For the purposes of promoting and understanding the principles of the present disclosure, reference will now be made to the embodiments illustrated in the drawings, and specific language will be used to describe the same. It is nevertheless understood that no limitation to the scope of the disclosure is intended. Any alterations and further modifications to the described devices, systems, and methods, and any further application of the principles of the present disclosure are fully contemplated and included within the present disclosure as would normally occur to one skilled in the art to which the disclosure relates. In particular, it is fully contemplated that the features, components, and/or steps described with respect to one embodiment may be combined with the features, components, and/or steps described with respect to other embodiments of the present disclosure, unless mutually exclusive. For the sake of brevity, however, the numerous iterations of these combinations will not be described separately. Features described in relation to a system, may be implemented in a computer implemented method and/or in a computer program product, in a corresponding manner.

Like numbered elements in these figures are either equivalent elements or perform the same function. Elements which have been discussed previously will not necessarily be discussed in later figures if the function is equivalent.

In an example, a medical system comprises a memory, storing machine-executable instructions. The medical system further comprises a computational system. Execution of the machine-executable instructions causes the computational system to receive measured k-space data. The measured k-space data comprises blades of k-space data acquired according to a PROPELLER magnetic resonance imaging protocol. The measured k-space data may be accompanied by the location in k-space they were acquired at, which may be used during the reconstruction of the magnetic resonance image. From these sampling locations, or any other description of the k-space trajectory, it would be apparent that the k-space data was acquired according to a PROPELLER magnetic resonance imaging protocol. The acronym PROPELLER refers to periodically rotated overlapping parallel lines with enhanced reconstruction. In a PROPELLER magnetic resonance protocol, k-space is sampled in rectangular blades, which are rotated relative to each other, in other words k-space sampling is done by using radially rotated Cartesian sampled strips or blades. The central region of k-space is repeatedly sampled by each blade and therefore oversampled. PROPELLER MRI is a common technique used to reduce or compensate for subject motion.

For the blades of k-space data, execution of the machine-executable instructions causes the computational system to reconstruct a blade specific image.

For the blades of k-space data, execution of the machine-executable instructions further causes the computational system to assign a spatially dependent weighting score to individual voxels of the blade specific image by comparing the blade specific image to a reference image. In this step, the individual voxels of the blade specific image are compared to a reference image. This allows the identification of individual voxels which may for example be degraded due to motion artifacts.

Execution of the machine-executable instructions further causes the computational system to reconstruct a magnetic resonance image by combining the blade specific images. The reconstruction of the magnetic resonance image is guided by using the spatially dependent weighting score of the individual voxels of the blade specific image for the respective blades of k-space data. Typically, when a PROPELLER magnetic resonance imaging protocol is followed, the motion correction is done on a blade level. In addition, other types of correction may be performed at the blade level. For example, if artifacts or motion perpendicular to the imaging plane are detected, an individual blade may be de-emphasized or even removed during the reconstruction. Embodiments have the benefit that a comparison is made in image space and individual portions of a blade specific image can be emphasized or de-emphasized in the reconstruction. This for example allows compensating for types of motion which a conventional PROPELLER reconstruction does not compensate for. For example, in abdominal imaging the motion of the subject may be very localized and may not affect an entire image. Guiding the reconstruction using the spatially dependent weighting score enables the motion correction to be more fine-tuned and effective than in a conventional PROPELLER reconstruction. The spatially dependent weighting score may help to locally de-emphasize structures in individual blades that are not consistent with the other blades. This can help to reduce residual localized motion artifacts but is different than explicit motion correction, in which the motion is estimated and explicitly inverted.

There are several causes of data inconsistencies between the blade-specific images. The first one is motion. Even in case of pure translation and rotation, since data acquisition is performed in two dimensions, (at least part of the) motion can be through plane, making the correction challenging and leading to inconsistencies even after motion correction. In the case of more complex motion, e.g., in the abdomen, translation and rotation cannot adequately correct the motion, leading to spatially dependent inconsistencies. Motion-related spatial inconsistencies between the images in different blades (potentially remaining after motion correction) can lead to blurring or streaking.

Another cause is magnetic resonance (MR) signals from outside the field of view (FOV). In Cartesian scans, one typically sets the readout direction in a way that aliasing from signal outside of the FOV can be avoided. In PROPELLER MRI, each blade is rotated in a different direction, thereby changing the readout direction. This may lead to different MR signals being visible for the different blades. For example, in knee imaging, a signal from the other knee may be visible in some blades and not in others. This inconsistency leads to streaking artifacts in the final image. Also flame artifacts at the edge of the FOV (caused by strong $B_0$ field inhomogeneities) may cause similar issues.

Such data inconsistencies between the individual blades are usually addressed by applying a weight in the data consistency term, thereby reducing the contribution of the inconsistent blade in the reconstruction. Examples may provide for an improved means of PROPELLER reconstruction. The use of the spatially dependent weighting score may be used to guide the reconstruction to de-emphasize only the portions of the images which are inconsistent. An entire blade does not need to be de-emphasized or ignored in the reconstruction.

In another example, the reconstruction of the magnetic resonance image is formulated as an optimization problem to iteratively minimize a cost function. The cost function comprises a difference between the blade specific image and the projection of the magnetic resonance image obtained from a previous iteration onto a blade specific image space for the blades of k-space data. The cost function is for the overall reconstruction of the entire magnetic resonance image. The inclusion of the spatially dependent weighting score in the optimization problem enables the compensation of motion which is corrupting just portions of particular blades. This example may be beneficial because it may provide for an improved means of reconstructing a PROPELLER magnetic resonance image.

In another example, the optimization problem further comprises weighting the cost function with the spatially dependent weighting score for the blade specific images before minimization. This example is beneficial because it provides for a very effective means of compensating for local motion that is present in only a few of the blade specific images.

This may for example be implemented by using a matrix of spatial weights (the spatially dependent weighting score) that reflect the spatial consistency between the images for each blade and for a reference blade. The weights range between 0 and 1, 1 corresponding to full consistency (i.e. a perfect match) and 0 corresponding to no consistency at all. The weights may be computed at the lower resolution supported by all blades and interpolated to the resolution of each blade. A normalization step may be performed such that the sum of the weights at each spatial location is equal (e.g. to 1) to ensure that no intensity variations are introduced.

The spatial weights are integrated in the PROPELLER reconstruction to suppress spatially localized inconsistencies between the blades. This can be done in several different ways as described below.

The matrix with spatial weights for each blade W = [$W_1$, $W_2$, ... $W_N$] may for example be introduced into the data consistency term of a PROPELLER reconstruction:

$$\hat{I} = argmin_I \sum_b \| W_b(I_b - P_b I)\|^2 . \qquad \text{Eq. (1)}$$

Here, I is the image to be reconstructed, $W_b$ is the spatial weighting matrix for blade *b*, $P_b$ is the projection of the image to blade b (consisting of an NUFFT using the trajectory for blade *b* and an adjoint NUFFT/Cartesian 2D FFT), and $I_b$ is the image for blade *b* (obtained by an adjoint NUFFT/Cartesian 2D FFT) from the measured data for blade *b*.

In another example, the magnetic resonance imaging protocol is a compressed sensing magnetic resonance imaging protocol. An exemplary modification of Equation (1) incorporating a residual term is:

$$\hat{I} = argmin_I \sum_b \| W_b(I_b - P_b I)\|^2 + R\,(I). \qquad \text{Eq. (2)}$$

Equation (2) is the same as Equation (1) with the addition of the regularization term *R(I). R(I)* can be defined for example as a $L_1$ regularization (for compressed sensing (CS)), a generic denoiser (plug-and-play (PnP)), or a learned regularizer (artificial intelligence (AI)-based reconstruction). *R(I)* provides a means of modifying Equation (1) to incorporate additional image reconstruction algorithms or modifications. For a compressed sensing reconstruction, *R(I)* is a sparsity promoting regularization for example the $L_1$ norm of the wavelet transform of the image. This example may be beneficial because it may provide for an effective means of incorporating compressed sensing into the reconstruction algorithm. This may improve image quality while reducing the amount of data that needs to be collected.

In another example, the magnetic resonance imaging protocol is a parallel imaging magnetic resonance imaging protocol. The blade specific images and the projection of the magnetic resonance image obtained from a previous iteration to a solution of the optimization problem onto the blade specific image space are calculated for individual coil elements. This example may be beneficial because the use of parallel imaging is an efficient means of accelerating imaging.

It can be beneficial to include the coil dimension in Equations (1) and (2), leading in the case of Equation (2) to

$$\widehat{I} = argmin_I \sum_b \sum_c \left\| W_b (I_{b,c} - P_{b,c} I) \right\|^2 + R(I), \quad \text{Eq. (3)}$$

where $P_{b,c}$ is the projection to each blade *b* and each coil element *c* and $I_{b,c}$ are the images for each blade and each coil element. The weights for each blade are constant over the coil dimension.

A PROPELLER reconstruction using Equation (1), (2) or (3) can be used to reduce localized spatial inconsistencies even in the case that no motion correction is applied. In the case that motion correction is applied there are two exemplary options to include it in the reconstruction.

1. Motion correction may be applied for each blade before the joint blade reconstruction. In this case Equations (1) to (3) still hold, provided that $I_b$ and $I_{b,c}$ are replaced by the motion-corrected images for each blade and each blade and coil, respectively.
2. The rigid or affine forward motion operator may be integrated in the projection on each blade. In this case, the projection operator is modified. This option is computationally more demanding but may be advantageous if the forward motion operator is easier to estimate than the inverse one.

In another example, execution of the machine-executable instructions further causes the computational system for the blades of k-space data to determine a motion estimate using the blade specific image before assigning the spatially dependent weighting score and to perform motion correction on the blade specific image before assigning the spatially dependent weighting score if the motion estimate is above a predetermined motion threshold. In this example, the blade specific images have motion correction performed on them. This may for example involve rotations and translations for rigid body motion correction. Performing the motion correction before assigning the spatially dependent weighting score may provide for improved image quality.

In another example, the motion correction comprises deleting the blade specific image. For example, if the motion is perpendicular to the plane or if there is too much image corruption due to complex motion of the subject, then it may be better to delete the blade specific image, which is equivalent to giving the entire blade a weighting value of zero.

In another example, the motion correction comprises translating the blade specific image using the motion estimate and/or rotating the blade specific image using the motion estimate. This may for example provide for an effective means of addressing rigid body motion of the subject.

In another embodiment, the medical system further comprises a magnetic resonance imaging system. The memory further stores pulse sequence commands configured to control the magnetic resonance imaging system to acquire the measured k-space data according to the PROPELLER magnetic resonance imaging protocol.

In another example, the reference image is a predetermined image of the blade specific images for the blades of k-space data. For example, one of the blade specific images can be selected as the reference image. This may for example provide for an effective and computationally efficient means of providing the predetermined image.

In another example, execution of the machine-executable instructions further causes the computational system to calculate an intermediate composite image by summing at least two of the blade specific images and providing the intermediate composite image as the reference image. The use of the intermediate composite image as the reference image may be beneficial in that the averaging may provide for an intermediate image that shows not only more detail but also possibly is less susceptible to motion.

In another example, execution of the machine-executable instructions further causes the computational system to determine a similarity metric between the intermediate composite image and at least two of the blade specific images. Execution of the machine-executable instructions further causes the computational system to recalculate the intermediate composite image by omitting any blade specific image with a similarity metric that meets a predetermined criterion from the summation. In this example, the intermediate composite image is first constructed by summing at least two of the blade specific images and possibly all of them and then going back and comparing the individual blade specific images to this intermediate composite image. Blade specific images which differ from the intermediate composite image by more than the predetermined criterion are then deleted from the intermediate composite image. This may for example provide for an effective means of preventing images which have distortions, motion artifacts or other artifacts from affecting the intermediate composite image too much.

In another example, assignment of the spatially dependent weighting score to the individual voxels of the blade specific image is performed by inputting the blade specific image and the reference image into a comparison algorithm. The comparison algorithm may be implemented in several different ways. A structural similarity index measure may be used, a cosine similarity index measure (example of a similarity metric) may be used, and an adaptive weighted averaging algorithm may also be used. All of these algorithms may provide for an effective means of identifying individual regions of blade specific images that should be labeled as having motion artifacts. These three techniques are discussed in greater detail below:

To address local spatial consistency/inconsistency between the images for each blade and a reference blade, weights could be computed in a sliding-window manner for each pixel location.
Extracted patches of size $k \times k$ from both images can be reshaped into 1D vectors $\vec{a}$ and $\vec{b}$. Note that, generally speaking, these vectors can be complex. Then different approaches could be used to determine how similar these vectors/local areas are:

1) Use a local Structural Similarity (SSIM) index. SSIM considers three key image quality aspects: luminance, contrast, and structure. It is used to evaluate the perceptual quality of an image by measuring how well the structural information, texture, and details are preserved after a particular transformation or degradation. Since the SSIM index ranges from -1 to 1 and the weights need to be positive, it could be shifted by adding 1.
2) Use a cosine similarity index. The cosine similarity index measures the cosine of the angle between two non-zero vectors in a multi-dimensional space. To force it to a range from 0 to 1, the magnitude of the dot product can be taken. This metric is sensitive to the orientation of vectors but not to their lengths or scale. It can be as:

$$cosine\ similarity = \frac{Magnitude(dot\ product\ (\vec{a},\vec{b}))}{Magnitude(\vec{a}) * Magnitude(\vec{b})}.$$

A higher power, for example of 2 or higher, of the index can be used to achieve a larger dynamic range and to decrease the smoothness.
3) Compute adaptive weights similarly to the approach presented in Gadjimuradov et. al. in the context of reducing artifacts from motion-related signal dropout in Diffusion-Weighted Imaging (DWI). The algorithm's rationale is to compute differences of representations (means) of extracted patches with respect to some reference value and to penalize corresponding pixels with lower weight if those differences are unlikely to be the result of random image noise. Patches are represented by their means and standard deviations. The reference value is a mean value from the reference patch.

Weights can be computed as:

$$w_{i,n} = f\left(d_{i,n}\,;\ s_i, \vartheta, \gamma\right) = g\left(d_{i,n}\,;\ s_i, \vartheta, \gamma\right) - g\left(d_{i,n}\,;\ -s_i, \vartheta, \gamma\right),$$

$$n = 1, \ldots, N,$$

where:

i indicates the location of the center of the patch,
$N$ is the number of blades,

$$g(d;\ s, \vartheta, \gamma) = \frac{1}{1 + e^{-\frac{\gamma}{\|\vartheta s\|}\cdot(d + \vartheta s)}},$$

$d_i = \mu_i - m_i \cdot 1_N$ are the differences between the mean for each patch and for the corresponding patch in the reference blade,
$\mu_j = [\mu_{i,1}, \ldots, \mu_{i,N}]^T$ is a vector of the mean values for the corresponding patches at location i and all blades,
$\sigma_i = [\sigma_{i,1}, \ldots, \sigma_{i,N}]^T$ is a vector of the standard deviations for the corresponding patches at location i and all blades,
$S_i = median(\sigma_i)$ - is the median of the vector of standard deviations for a given patch location and all blades,
$\vartheta, \gamma$ are hyperparameters that control steepness at the cutoff points defined by $S_i$ and the width of the tolerance margin, respectively.

For all three approaches described above, weights may be calculated for all blades, including the reference blade. After the weights are computed, they may be normalized in a way that the sum of the weights for each voxel is 1.
In another example, the memory further comprises a comparison neural network configured to output the spatially dependent weighting score in response to receiving the blade specific image and the reference image as input. Execution of the machine-executable instructions further causes the computational system to receive the spatially dependent weighting score in response to inputting the blade specific image and the reference image into the comparison neural network. Using the comparison neural network may be very effective in assigning the spatially dependent weighting score.

The comparison neural network may be implemented in several different ways. For example, the comparison neural network may be a neural network that is configured for receiving image data. The size of the input layer can be increased to accommodate both the reference image and the blade specific image. The output of the comparison neural network can then be configured to output an image equivalent to the size of the blade specific image and instead of outputting image values it outputs the individual weighting score for each voxel. The neural networks which are used for image processing such as a U-net, a ResNet, a convolutional neural network and also a neural network with multiple hidden layers that are fully connected may all be used effectively for this task. The comparison neural network may be trained by collecting pairs of training data. For example, the input image or test image during training may be a pair of a training blade specific image and a training reference image and this may again be compared against ground truth data which represents the spatially dependent weighting score. The spatially dependent weighting score may for example be assigned manually or one of the implementations of the comparison algorithm may be used to provide these values. Once a large number of pairs of training data have been acquired, they may for example be trained using a deep learning training technique. The training data can also be simulated by adding local deformations/inconsistencies. Since this is a generic similarity weight, the training images do not need to be MRI images.

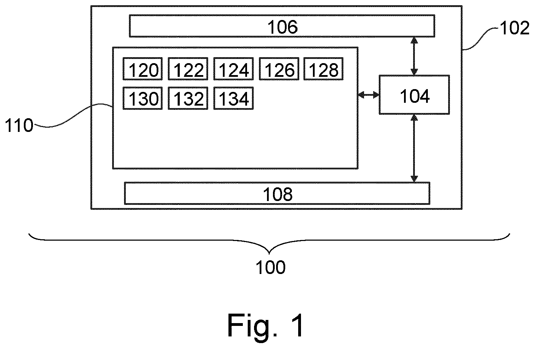

Fig. 1 illustrates an example of a medical system 100. The medical system 100 is shown as comprising a computer 102. The computer 102 may be one or more computers located at one or more locations. In some examples the computer 102 could be accessible via a network or the internet. For example, it may be used for providing a cloud-based service. The computer 102 is shown as comprising a computational system 104. The computational system 104 is intended to represent one or more computational systems or computing cores located at one or more locations. The computational system 104 is shown as being connected to an optional hardware interface 106. The hardware interface 106 may be used to control other components such as a magnetic resonance imaging system if they are present. The computational system 104 is further shown as being connected to an optional user interface. The user interface 108 may be used for such things as displaying or rendering magnetic resonance images or for providing a user interface for controlling and operating the medical system 100. The computational system 104 is further shown as being connected to a memory 110. The memory 110 is intended to represent various types of memory accessible to the computational system 104. In one example the memory 110 is a non-transitory storage medium.

The memory 110 is shown as storing machine-executable instructions 120. The machine-executable instructions 120 enable the computational system 104 to control other components of the medical system 100 as well as perform various numerical and image processing tasks. The memory 110 is further shown as containing measured k-space data 122. It may for example be received via a network connection or it may be acquired when a magnetic resonance imaging system is part of the medical system 100. The measured k-space data has been acquired according to a PROPELLER magnetic resonance imaging protocol. The measured k-space data 122 comprises blades of k-space data. For each blade there is a blade specific image 124 which has been reconstructed from it. The blade specific image 124 is a lower resolution or undersampled image. The memory 110 is further shown as containing a reference image 126. The reference image 126 may for example be one of the blade specific images 124 or may be a composite image made from multiple blade specific images 124.

The memory 110 is further shown as containing a spatially dependent weighting score 128 that is individually assigned to each of the blade specific images 124. The spatially dependent weighting score 128 is a measure of the similarity between the blade specific image 124 and the reference image 126. The memory 110 is further shown as containing an optional comparison algorithm 130 that may receive the blade specific image 124 and the reference image 126 as input and then output the spatially dependent weighting score 128. The memory 110 is further shown as containing an optional comparison neural network 132 that may be used in place of the comparison algorithm 130. The optional comparison neural network 132 is configured to receive the blade specific image 124 and the reference image 126 as input and in response to output the spatially dependent weighting score 128. The memory 110 is further shown as containing a magnetic resonance image 134 that has been reconstructed from the blade specific images 124 using their spatially dependent weighting score 128 to guide the reconstruction to avoid regions of the blade specific images 124 that have imaging artifacts and are or show motion artifacts.

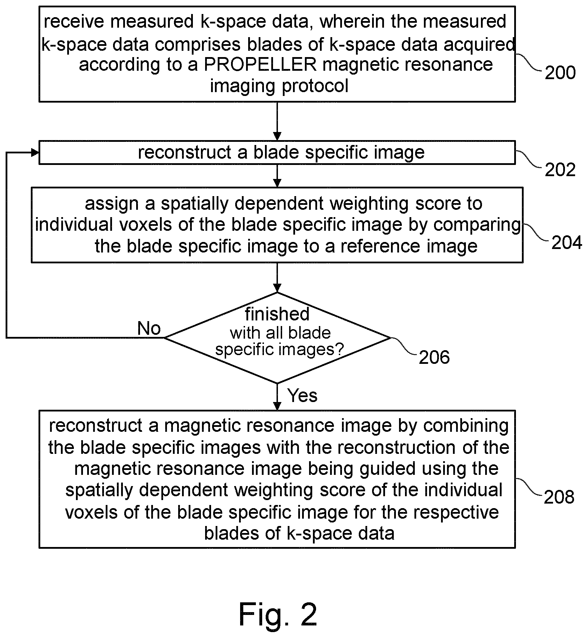

Fig. 2 shows a flowchart which illustrates a method of operating the medical system 100 of Fig. 1. In step 200 the measured k-space data 122 is received. The measured k-space data comprises blades of k-space data acquired according to a PROPELLER magnetic resonance imaging protocol. In step 202 a blade specific image is reconstructed. In step 204 the spatially dependent weighting score 128 is assigned to individual voxels of the blade specific image by comparing the blade specific image 124 to a reference image 126. In block 206 there is a question box. The question is: finished with all blade specific images? If the answer is "no," then the method returns back to step 202 and the process is repeated for each blade. If the answer is "yes," the method proceeds to block 208 where the magnetic resonance image 134 is reconstructed by combining the blade specific images 124 with the reconstruction of the magnetic resonance image 134 being guided using the spatially dependent weighting score 128 of the individual voxels of the blade specific image for the respective blades of k-space data.

In Fig. 2 it was illustrated that each of the blade specific images were processed separately. However, this need not to be the case. For example, all of the blade specific images 124 may be reconstructed at the same time. After this, the spatially dependent weighting score could be assigned 204. The process illustrated in Fig. 2 is therefore a single embodiment.

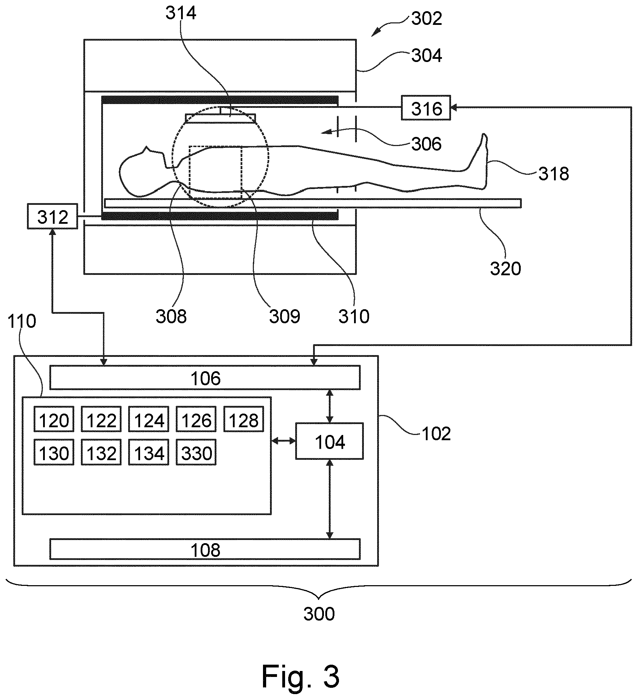

Fig. 3 illustrates a further example of a medical system 300. The medical system 300 is similar to the medical system 100 depicted in Fig. 1 except that it additionally comprises a magnetic resonance imaging system 302, which is being controlled by the hardware interface 106.

The magnetic resonance imaging system 302 comprises a magnet 304. The magnet 304 is a superconducting cylindrical type magnet with a bore 306 through it. The use of different types of magnets is also possible; for instance it is also possible to use both a split cylindrical magnet and a so-called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject: the arrangement of the two sections area similar to that of a Helmholtz coil. Open magnets are popular, because the subject is less confined. Inside the cryostat of the cylindrical magnet there is a collection of superconducting coils.

Within the bore 306 of the cylindrical magnet 304 there is an imaging zone 308 where the magnetic field is strong and uniform enough to perform MRI. A field of view 309 is shown within the imaging zone 308. The k-space data is typically acquired for the field of view 309. The region of interest could be identical with the field of view 309 or it could be a sub volume of the field of view 309. A subject 318 is shown as being supported by a subject support 320 such that at least a portion of the subject 318 is within the imaging zone 308 and the field of view 309.

Within the bore 306 of the magnet there is also a set of magnetic field gradient coils 310 which is used for acquisition of (preliminary) k-space data to spatially encode magnetic spins within the imaging zone 308 of the magnet 304. The magnetic field gradient coils 310 are connected to a magnetic field gradient coil power supply 312. The magnetic field gradient coils 310 are intended to be representative. Typically, the magnetic field gradient coils 310 contain three separate sets of coils for spatial encoding in three orthogonal spatial directions. A magnetic field gradient power supply supplies current to the magnetic field gradient coils. The current supplied to the magnetic field gradient coils 310 is controlled as a function of time and may be ramped or pulsed.

Adjacent to the imaging zone 308 is a radio-frequency coil 314 for manipulating the orientations of magnetic spins within the imaging zone 308 and for receiving radio transmissions from spins also within the imaging zone 308. The radio-frequency antenna may contain multiple coil elements. The radio-frequency antenna may also be referred to as a channel or antenna. The radio-frequency coil 314 is connected to a radio-frequency transceiver 316. The radio-frequency coil 314 and radio-frequency transceiver 316 may be replaced by separate transmit and receive coils and a separate transmitter and receiver. It is understood that the radio-frequency coil 314 and the radio-frequency transceiver 316 are representative. The radio-frequency coil 314 is intended to also represent a dedicated transmit antenna and a dedicated receive antenna. Likewise, the transceiver 316 may also represent a separate transmitter and receiver. The radio-frequency coil 314 may also have multiple receive/transmit elements and the radio-frequency transceiver 316 may have multiple receive/transmit channels. The transceiver 316 and the gradient controller 312 are shown as being connected to the hardware interface 106 of the computer system 102.

The memory 110 is further shown as comprising pulse sequence commands which are configured to acquire the measured k-space data 122 according to a PROPELLER magnetic resonance imaging protocol.

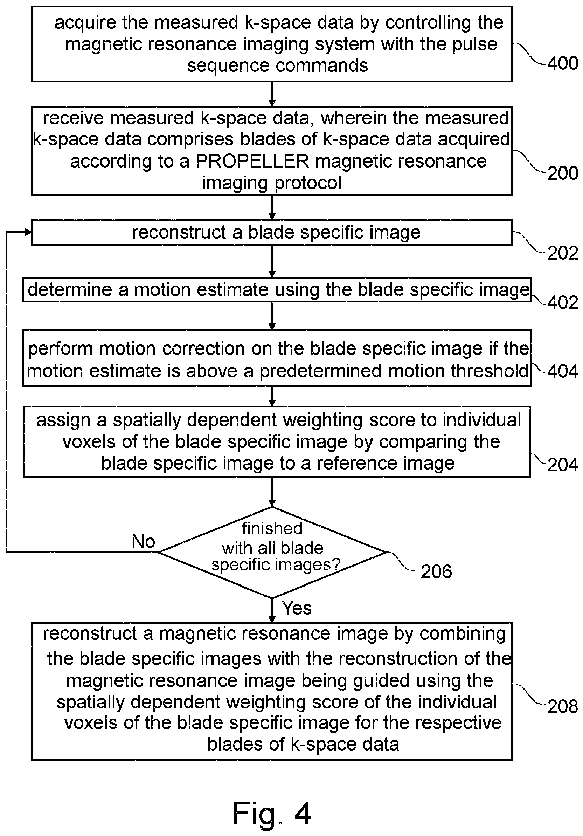

Fig. 4 shows a flowchart which illustrates a method of controlling the medical system 300 of Fig. 3. In step 400 the measured k-space data 122 is acquired by controlling the magnetic resonance imaging system 302 with the pulse sequence commands 330. Steps 200 and 202 are then performed as was illustrated in Fig. 2. In step 402 a motion estimate or approximation is optionally determined for each blade specific image. This may be the motion estimate that is commonly performed for a PROPELLER motion correction. In step 206 motion correction is optionally performed on individual blade specific images if the motion estimate for that particular blade specific image is above a predetermined motion threshold. Optional steps 402 and 404 perform motion correction before the spatially dependent weighting score is assigned to individual voxels. After step 404, steps 204, 206, and 208 are performed as was illustrated in Fig. 2. The predetermined motion threshold may for example be determined empirically based on historically preceding images of a same patient or of a patent population in view of the expected image quality with respect to preventing motion related artifacts. In an alternative embodiment the predetermined motion threshold is controllable by a user of the MR system through a user interface by at least one of the following: inputting a number, dragging a slider within a given interval, selecting from a set of discrete values.

In this example the blade specific images are reconstructed individually. However, the blade specific images may be all reconstructed at a single time. Particularly if motion correction is performed it may be beneficial to have all of the blade specific images available to perform the motion correction for the entire ensemble of blade specific images.

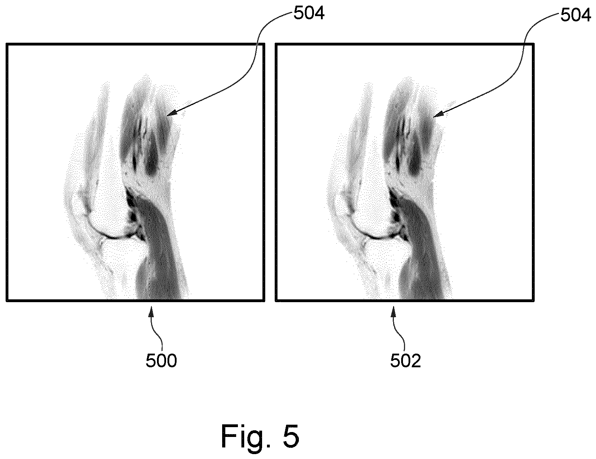

Fig. 5 illustrates two different magnetic resonance images 500 and 502. Image 500 illustrates a magnetic resonance image without the image correction. An artifact location 504 is marked on the magnetic resonance image 500. An inconsistency between some blades and the other blades leads to streaking artifacts in the final image. Magnetic resonance image 502 shows the same image using motion correction according to an example. At the location 504 it can be seen that the artifact is not present anymore.

It is understood that one or more of the aforementioned examples or embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer-readable medium(s) having computer executable code embodied thereon.

Any combination of one or more computer-readable medium(s) may be utilized. The computer-readable medium may be a computer-readable signal medium or a computer-readable storage medium. A 'computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer-readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer-readable-storage medium also refers to various types of recording media capable of being accessed by the computer device via a network or communication link. For example, data may be retrieved over a modem, over the internet, or over a local area network. Computer executable code embodied on a computer-readable medium may be transmitted using any appropriate medium, including but not limited to wireless, wire line, optical fiber cable, RF, etc., or any suitable combination of the foregoing.

A computer-readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer-readable signal medium may be any computer-readable medium that is not a computer-readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a computational system. 'Computer storage' or 'storage' is a further example of a computer-readable storage medium. Computer storage is any non-volatile computer-readable storage medium. In some embodiments computer storage may also be computer memory or vice versa.

A 'computational system' as used herein encompasses an electronic component which is able to execute a program or machine-executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine-executable code or instructions may be executed by multiple computational systems or processors that may be within the same computing device or which may even be distributed across multiple computing devices.

Machine-executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine-executable instructions. In some instances, the computer executable code may be in the form of a high-level language or in a pre-compiled form and be used in conjunction with an interpreter which generates the machine-executable instructions on the fly. In other instances, the machine-executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a Local Area Network (LAN) or a Wide Area Network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further understood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine-executable instructions or computer program instructions may also be stored in a computer-readable medium that can direct a computer, other programmable data processing apparatus, or other devices to function in a particular manner, such that the instructions stored in the computer-readable medium produce an article of manufacture including instructions which implement the function/act specified in the flowchart and/or block diagram block or blocks.

The machine-executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A ‘user interface’ as used herein is an interface which allows a user or operator to interact with a computer or computer system. A ‘user interface’ may also be referred to as a ’human interface device.’ A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator’s control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A ‘hardware interface’ as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include but are not limited to: a universal serial bus, IEEE 1394 port, parallel port, IEEE 1284 port, serial port, RS-232 port, IEEE-488 port, Bluetooth connection, wireless local area network connection, TCP/IP connection, Ethernet connection, control voltage interface, MIDI interface, analog input interface, and digital input interface.

A ’display’ or ‘display device’ as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen, Cathode Ray Tube (CRT), storage tube, bi-stable display, electronic paper, vector display, flat panel display, Vacuum Fluorescent (VF) display, Light-Emitting Diode (LED) displays, Electroluminescent display (ELD), Plasma Display Panels (PDP), Liquid Crystal Display (LCD), Organic Light-Emitting Diode (OLED) displays, a projector, and head-mounted display.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

## Claims

1. A medical system (100, 300) comprising a processor configured to:

   receive (200) measured k-space data (122), wherein the measured k-space data comprises blades of k-space data acquired according to a rotated magnetic resonance imaging protocol;
   for the blades of the k-space data, reconstruct (202) a blade-specific image (124); and assign (204) a spatially dependent weighting score (128) to individual voxels of the blade-specific image by comparing the blade-specific image to a reference image (126);
   reconstruct (208) a magnetic resonance image (134, 502) by combining the blade-specific images, wherein the reconstruction of the magnetic resonance image is guided using the spatially dependent weighting score of the individual voxels of the blade specific image for the respective blades of k-space data.

2. The medical system of claim 1, wherein the reconstruction of the magnetic resonance image is formulated as an optimization problem to iteratively minimize a cost function, wherein the cost function comprises a difference between the blade specific image and the projection of the magnetic resonance image obtained from a previous iteration onto a blade specific image space for the blades of k-space data.

3. The medical system of claim 2, wherein the optimization problem further comprises weighting the cost function with the spatially dependent weighting score for the blade specific images before minimization.

4. The medical system of claim 2 or 3, wherein the magnetic resonance imaging protocol is a compressed sensing magnetic resonance imaging protocol, wherein the reconstruction of the magnetic resonance image further comprises adding a residual term that is dependent upon the magnetic resonance image obtained from the previous iteration to a solution of the optimization problem, and wherein the residual term is calculated using a compressed sensing reconstruction algorithm.

5. The medical system of any one of claims 1 to 4, wherein the magnetic resonance imaging protocol is a parallel imaging magnetic resonance imaging protocol, wherein the blade-specific images and the projection of the magnetic resonance image obtained from a previous iteration to a solution of the optimization problem onto the blade specific image space are calculated for individual coil elements.

6. The medical system of any one of the preceding claims, wherein the processor is configured for the blades of the k-space data to:

   determine (402) a motion estimate using the blade specific image before assigning the spatially dependent weighting score; and
   perform (404) motion correction on the blade specific image before assigning the spatially dependent weighting score if the motion estimate is above a predetermined motion threshold.

7. The medical system of claim 6, wherein the motion correction comprises any one of the following:

   deleting the blade specific image; and
   translating the blade specific image using the motion estimate and/or rotating the blade-specific image using the motion estimate.

8. The medical system of any one of the preceding claims, wherein the medical system further comprises a magnetic resonance imaging system (302) configured to acquire (400) the measured k-space data by controlling the magnetic resonance imaging system with pulse sequence commands (330).

9. The medical system of any one of the preceding claims, wherein the reference image is a predetermined image of the blade specific images for the blades of k-space data.

10. The medical system of any one of claims 1 to 8, wherein the processor is configured to:

    calculate an intermediate composite image by summing at least two of the blade specific images; and
    provide the intermediate composite image as the reference image.

**11.** The medical system of claim 10, wherein the processor is configured to:

determine a similarity metric between the intermediate composite image and the at least two of the blade specific images; and
recalculate the intermediate composite image by omitting any blade specific image with a similarity metric that meets a predetermined criterion from the summation.

**12.** The medical system of any one of the preceding claims, wherein assignment of the spatially dependent weighting score to individual voxels of the blade specific image is performed by inputting the blade specific image and the reference image into a comparison algorithm, wherein the comparison algorithm is any one of the following: a structural similarity index measure, a cosine similarity index measure, and an Adaptive Weighted Averaging algorithm.

**13.** The medical system of any one of claims 1 to 11, wherein the processor is configured to receive the spatially dependent weighting score in response to inputting the blade specific image and the reference image into a comparison neural network.

**14.** A method of medical imaging comprising:

receiving (200) measured k-space data (122), wherein the measured k-space data comprises blades of k-space data acquired according to a rotated magnetic resonance imaging protocol;
for the blades of the k-space data, reconstructing (202) a blade specific image (124) and assigning (204) a spatially dependent weighting score (128) to individual voxels of the blade-specific image by comparing the blade specific image to a reference image (126);
reconstructing (208) a magnetic resonance image (134) by combining the blade-specific images, wherein the reconstruction of the magnetic resonance image is guided using the spatially dependent weighting score of the individual voxels of the blade specific image for the respective blades of k-space data.

**15.** The system of any of the claims 1 to 13 or the method of claim 14, wherein the rotated magnetic resonance imaging protocol comprises periodically rotated magnetic resonance imaging protocol, preferably a periodically rotated overlapping parallel lines with enhanced reconstruction, PROPELLER, magnetic resonance imaging protocol.

106
102
120
122
124
126
128
130
132
134
104
110
108
100

Fig. 1

receive measured k-space data, wherein the measured k-space data comprises blades of k-space data acquired according to a PROPELLER magnetic resonance imaging protocol
200
reconstruct a blade specific image
202
assign a spatially dependent weighting score to individual voxels of the blade specific image by comparing the blade specific image to a reference image
204
finished with all blade specific images?
No
206
Yes
reconstruct a magnetic resonance image by combining the blade specific images with the reconstruction of the magnetic resonance image being guided using the spatially dependent weighting score of the individual voxels of the blade specific image for the respective blades of k-space data
208

Fig. 2

314
302
304
316
306
318
312
320
308
309
310
110
106
120
122
124
126
128
130
132
134
330
104
102
108
300

Fig. 3

acquire the measured k-space data by controlling the magnetic resonance imaging system with the pulse sequence commands
400
receive measured k-space data, wherein the measured k-space data comprises blades of k-space data acquired according to a PROPELLER magnetic resonance imaging protocol
200
reconstruct a blade specific image
202
determine a motion estimate using the blade specific image
402
perform motion correction on the blade specific image if the motion estimate is above a predetermined motion threshold
404
assign a spatially dependent weighting score to individual voxels of the blade specific image by comparing the blade specific image to a reference image
204
finished with all blade specific images?
No
206
Yes
reconstruct a magnetic resonance image by combining the blade specific images with the reconstruction of the magnetic resonance image being guided using the spatially dependent weighting score of the individual voxels of the blade specific image for the respective blades of k-space data
208

Fig. 4

504
504
500
502

Fig. 5

Europäisches
Patentamt
European
Patent Office
Office européen
des brevets

# EUROPEAN SEARCH REPORT

Application Number
EP 24 15 5755

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | US 2017/307716 A1 (DE WEERDT ELWIN [NL]) 26 October 2017 (2017-10-26)<br>* the whole document *<br>----- | 1-10, 12-15<br>11 | INV.<br>G01R33/565<br>G01R33/48<br>G01R33/56 |
| X<br>A | EP 3 123 191 A1 (KONINKLIJKE PHILIPS NV [NL]) 1 February 2017 (2017-02-01)<br>* the whole document *<br>----- | 1,8,9, 13-15<br>4,11 | |
| A | MALCZEWSKI KRZYSZTOF ED - SALIKHOV KEV M: "Rapid Diffusion Weighted Imaging with Enhanced Resolution", APPLIED MAGNETIC RESONANCE, SPRINGER VERLAG, VIENNA, AU, vol. 51, no. 3, 16 January 2020 (2020-01-16), pages 221-239, XP037052771, ISSN: 0937-9347, DOI: 10.1007/S00723-019-01185-X [retrieved on 2020-01-16]<br>* the whole document *<br>----- | 1-15 | |
| | | | TECHNICAL FIELDS SEARCHED (IPC) |
| A | GADJIMURADOV FASIL ET AL: "Deep learning-guided weighted averaging for signal dropout compensation in DWI of the liver", MAGNETIC RESONANCE IN MEDICINE, vol. 88, no. 6, 2 August 2022 (2022-08-02), pages 2679-2693, XP093177461, US ISSN: 0740-3194, DOI: 10.1002/mrm.29380 Retrieved from the Internet: URL:https://onlinelibrary.wiley.com/doi/full-xml/10.1002/mrm.29380><br>* the whole document *<br>----- | 1-15 | G01R |

The present search report has been drawn up for all claims

| Place of search | Date of completion of the search | Examiner |
|---|---|---|
| Munich | 24 June 2024 | Durst, Markus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 24 15 5755

This annex lists the patent family members relating to the patent documents cited in the above-mentioned European search report. The members are as contained in the European Patent Office EDP file on
The European Patent Office is in no way liable for these particulars which are merely given for the purpose of information.

24-06-2024

| Patent document cited in search report | Publication date | Patent family member(s) | Publication date |
|---|---|---|---|
| US 2017307716 A1 | 26-10-2017 | CN 106796274 A | 31-05-2017 |
| | | EP 3204784 A1 | 16-08-2017 |
| | | JP 2017529960 A | 12-10-2017 |
| | | RU 2017115944 A | 12-11-2018 |
| | | US 2017307716 A1 | 26-10-2017 |
| | | WO 2016055462 A1 | 14-04-2016 |
| EP 3123191 A1 | 01-02-2017 | CN 106104292 A | 09-11-2016 |
| | | EP 3123191 A1 | 01-02-2017 |
| | | JP 6574439 B2 | 11-09-2019 |
| | | JP 2017512565 A | 25-05-2017 |
| | | US 2017115369 A1 | 27-04-2017 |
| | | WO 2015144568 A1 | 01-10-2015 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **GADJIMURADOV F.** Deep learning-guided weighted averaging for signal dropout compensation in DWI of the liver. *Magn Reson Med*, December 2022, vol. 88 (6), 2679-2693